Europäisches Patentamt

European Patent Office

Office européen des brevets

(11) Publication number: **0 174 163**
**B1**

(12) **EUROPEAN PATENT SPECIFICATION**

(45) Date of publication of patent specification: **28.03.90**

(51) Int. Cl.⁵: **H 05 K 5/00**

(21) Application number: **85306147.1**

(22) Date of filing: **30.08.85**

(54) Mounting and clamping devices.

(30) Priority: **01.09.84 GB 8422148**

(43) Date of publication of application:
**12.03.86 Bulletin 86/11**

(45) Publication of the grant of the patent:
**28.03.90 Bulletin 90/13**

(84) Designated Contracting States:
**DE FR GB**

(56) References cited:
**EP-A-0 116 463**
**DE-B-2 542 592**
**US-A-3 465 914**
**US-A-3 666 134**
**US-A-3 923 197**
**US-A-4 227 037**
**US-A-4 365 108**

**Revue Technique automobile, No. 399, reedited
1980, page 14, Boulogne-Billancourt, FR**

(73) Proprietor: **BRITISH AEROSPACE PUBLIC
LIMITED COMPANY
100 Pall Mall
London SW1Y 5HR (GB)**

(72) Inventor: **Ridgway, Peter Charles
British Aerospace p.l.c. Downshire Way
Bracknell Berkshire, RG12 1QL (GB)**

(74) Representative: **Saul, David Jonathan et al
British Aerospace plc Corporate Patents Dept.
Brooklands Road
Weybridge Surrey KT13 0SJ (GB)**

Courier Press, Leamington Spa, England.

## Description

This invention relates to mounting and clamping devices, more particularly but not exclusively for electronic equipment.

The embodiments of the invention to be described with reference to the drawings comprise a clamping arrangement for securing two portions of a box housing together. The box may contain a computer disc drive.

Known methods of clamping two portions of a box housing together include providing each portion of the box with a flange which is then secured to the other portion by means of a bolt passing through both flanges. One disadvantage with this method is that the flanges extend beyond the dimensions of the box and have to be allowed for when mounting the box (see for example US—A—3666134).

According to the invention, there is provided a clamping arrangement as claimed in claim 1.

Preferred embodiments of the present invention are as claimed in dependent claims 2 to 6.

For a better understanding of the invention, reference will be made, by way of example, to the accompanying drawings, in which:—

Figures 1, 2 and 3 are respectively an end view, a sectional elevation and a perspective view of a cradle,

Figure 4 is a perspective view of a slide strip,

Figure 5 is a perspective view of a box,

Figure 6 is a sectional view of part of the Figure 5 box showing a clamping strip,

Figures 7, 8 and 9 are respectively a plan, end and part sectional view of the clamping strip,

Figures 10 and 11 are respectively a plan and elevation of an eccentric camming member,

Figure 12 is a view, corresponding to Figure 6, but showing a modified clamp arrangement,

Figure 13 is a view, corresponding to Figure 6 but showing a rectilinear version of the clamp arrangement, and

Figure 14 is a diagrammatic view of a modified door fastener for the door of the cradle of Figures 1 to 3.

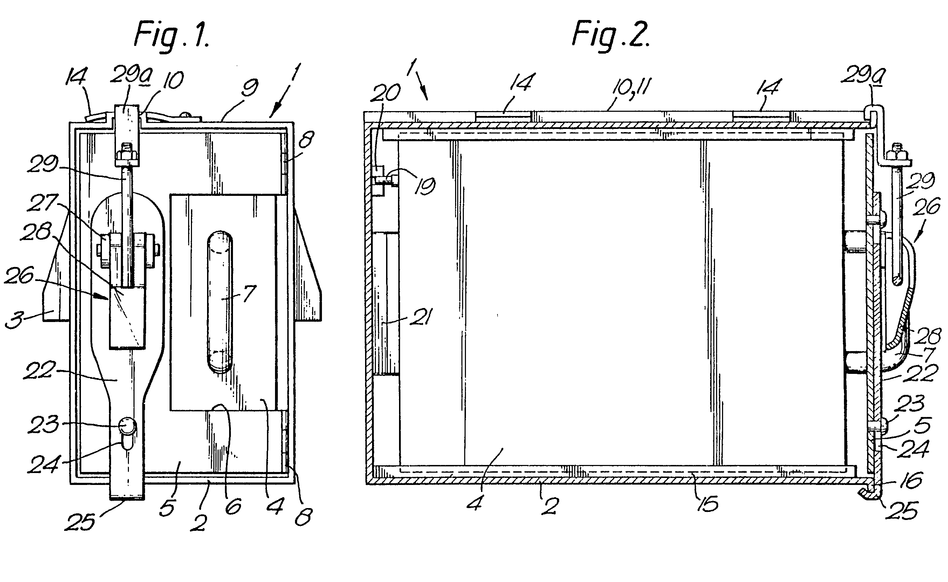

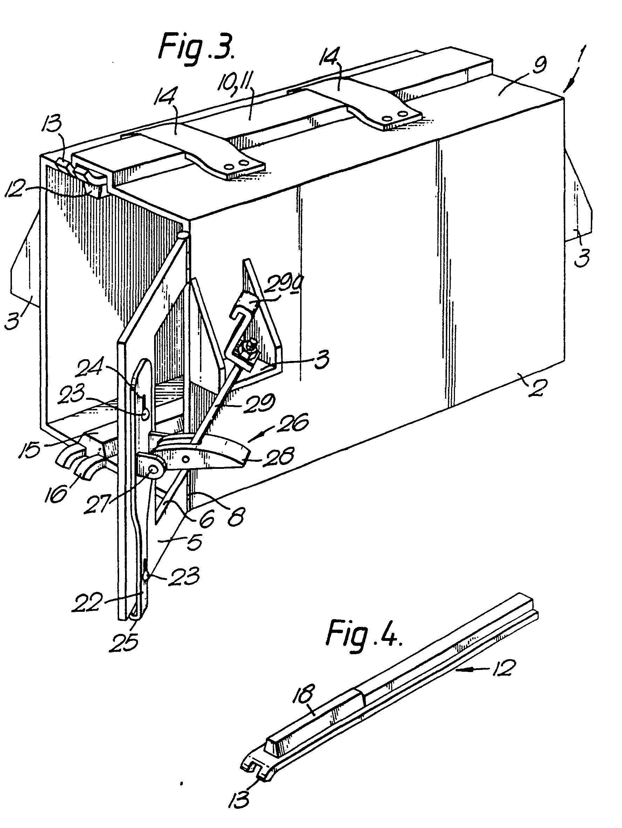

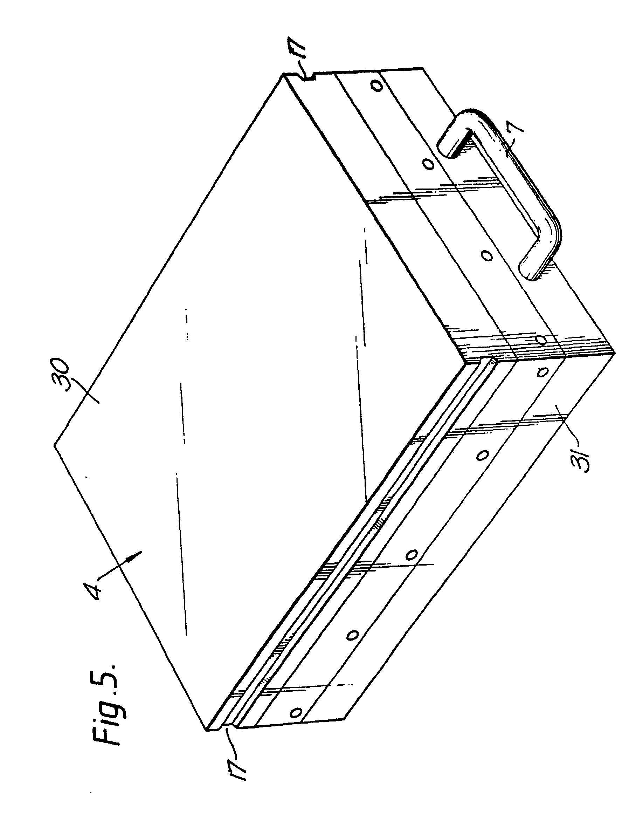

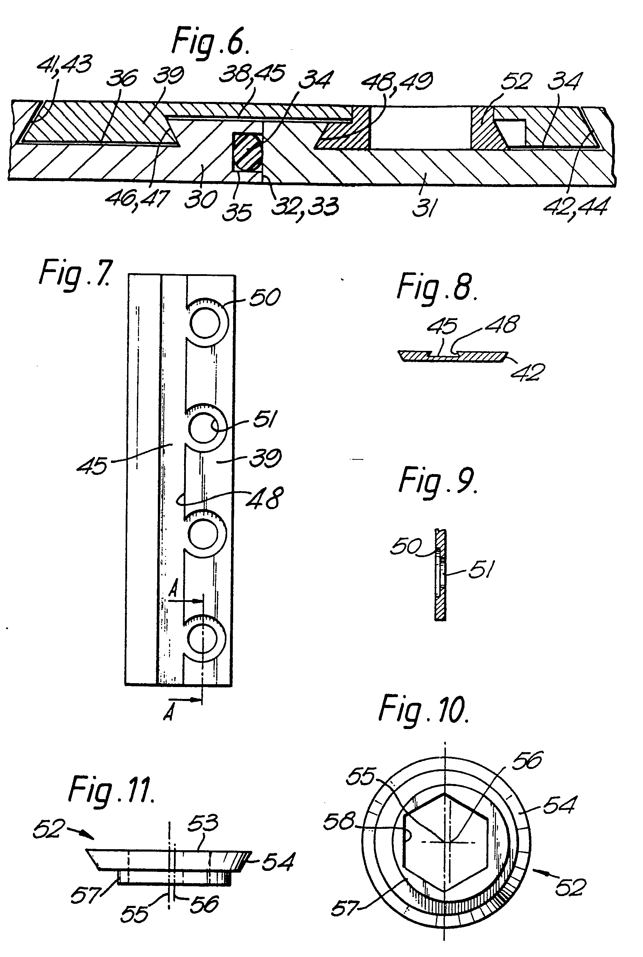

Referring to Figures 1 to 4, the cradle 1 comprises a rectangular box 2 made up of sheet metal or cast and having brackets 3 by which it may be mounted in an electronic equipment box (not shown) which, in turn, could be rack-mounted in an aircraft say. Within the cradle, there is installed a metal box 4 (also shown in Figure 5) housing a Winchester computer disc drive (not shown). Figures 1 and 2 show the box 4 installed in the cradle 1, while Figure 3 shows the cradle empty and with a door 5 thereof open. The door 5 is positioned at one end of the box 2 and it has a rectangular cut-out 6 in it to permit a handle 7 provided on box 4 to protrude from box 2. The door is secured by hinges 8. Extending lengthways along one of the narrow walls 9 of the box 2 there is a raised wall portion 10 defining an inwardly facing recess 11 wherein there is fitted a slide strip 12 with a hook 13 formed at the door end thereof. The raised wall portion 10 is apertured to expose the strip 12 at two places along its length and, at each of these, a shaped piece of spring steel 14 is secured to the strip and engages the outside of the wall 9 each side of the strip so as to urge the strip to remain fully retracted into the recess 11. That wall of box 2 which is opposite wall 9 has a fixed slide strip 15 fixed to it in alignment with the strip 12. Also, this wall has fixed to it, or integrally formed with it, a hook 16 at the door end of strip 15, *i.e.* opposite the hook 13.

As shown best in Figure 5, the box 4 has two grooves 17 extending along respective opposite walls, each groove having bevelled side-walls. Meanwhile, the slide strip 15 is also bevelled to match one of the grooves 17. The slide strip 12 could also be bevelled right along its length to match the other groove 17 but, for preference, it is as shown in Figure 4 with a short bevelled section 18, matching grooves 17, extending back from the hook or front end of the strip and then becoming narrower with a square section.

With the door 5 open, the box 4 can be slid into or out of box 2 with the grooves 17 engaging strips 12 and 15. Protruding from the rear of box 4 are one or more locating pins, such as the pin 19, which engage with corresponding holes, such as the hole 20, opening from the rear wall of box 2. Also, the two parts of a plug and socket 21 connector are provided at the rear walls of boxes 2 and 4, so that, when the box 4 is pushed home, the two parts mate to provide electrical connections between the disc drive and the electronic circuitry contained in the outer equipment box (not shown).

An elongate slide plate 22 is fixed to the door 5 by means of screws 23 extending through elongated holes 24 in the plate, so that the plate can slide up and down relative to the door. At its lower end, the plate 22 is provided with a hook 25 able to engage hook 16. Then, mounted on the plate 22, there is a so-called 'tension latch' or 'camlock' 26. This is a proprietary article, easily available from a number of manufacturers, which works on the same prinicple as the catches often used on suitcases and the like. Namely, it comprises a mounting trunnion 27 in which there is pivotably mounted a lever 28. A rod 29 is in turn pivotably mounted to the lever 28 at a point spaced from the pivot axis of the lever itself. To the rod, there is fixed a hook 29a which can engage the hook 13. With the lever 28 raised as shown in Figure 3, the door 5 can be closed and the hook 25 will pass just clear of hook 16. The hook 29a of the tension latch can then be moved to over the hook 13. The hook 29a is fixed to rod 29 by a nut to enable the position of hook 29a relative to the lever 28 to be adjusted for easy clearance. Then, the lever 28 can be pushed down towards plate 22, which action causes the plate 22 to be pulled up so that the hook 25 engages hook 16, and causes the hook 29a to be pulled down first into engagement with hook 13 of strip 12 and then further so that the strip 12 is pulled down against the action of springs 14 and the box 2 becomes clamped between the two strips 12 and 15. The construction of latch 26 is such that it has an over-centre action whereby, once the lever 28 is pushed fully down against plate 22, it remains there until lifted intentionally.

Referring now to Figures 5 to 11, the box 4 is made of aluminium or aluminium alloy, preferably by an investment casting process. It comprises two equal halves 30 and 31; the split being along the narrow walls of the box, and the mating edges 32 and 33 of the halves are hermetically sealed by an O-ring seal 34 housed in a groove 35 extending around the edge 32 of the box half 30. As shown best in Figure 6, the two halves of the box are provided with respective dove-tail recesses 36 and 37 which each extend right round the associated box half adjacent and parallel to the mating edge. The recess 37 is somewhat wider than recess 36 and the external surfaces of the portions 38 of the box walls between the recesses 36 and 37 lie a short distance in from the surfaces of the main portions of the box walls. A clamping strip 39 is fitted into the recesses in each wall of the box. Each strip 39 has its two long edges 41 and 42 bevelled to match the respective walls 43 and 44 of the recesses 36 and 37 which are furthest from the mating edges 32 and 33. The inwardly facing surface of each strip is formed with a recess 45 to receive the box wall portions 38, this recess having one bevelled wall 46 to match that wall 47 of dovetail recess 36 which is nearest edge 32. For most of its length, the other side of recess 45 terminates in a bevelled wall 48 matching and engaging that wall 49 of dovetail recess 37 which is nearest edge 33. However, at spaced positions along the length of each strip 39, there are formed respective circular wells 50 which extend in from the inwardly facing surface of the strip, between the recess 45 and the edge 42 thereof, and which each break out through the wall 48 of the recess 45 as best shown in Figures 7 to 9. The floor of each well 50 is provided with a concentric hole 51 extending through to the outwardly facing surface of the strip 39. Within each well 50 and associated hole 51, there is fitted an eccentric clamping member 52. As shown best in Figures 10 and 11, each member 52 comprises a circular disc-shaped portion 53 with a bevelled periphery 54 matching the wall 49 of recess 37. The disc-shaped portion 53 lies in the well 50. Extending out from the disc 53, with its central axis 55 offset from the central axis 56 of the disc-shaped portion 53, there is a circular spigot portion 57 which fits into the hole 51. The top surface of the spigot portion 57 is provided with a hexagonal recess 58 to receive an Allen key. In fact, one way of making each member 52 is to mount a suitable size of Allen screw in a lathe and to turn the disc portion from the head of the screw, then mount the screw slightly offset and turn the spigot portion also from the screw head, and then part off the unwanted part of the screw.

Initially, with the members 52 positioned in the wells 50 of each strip, the strip held so that the members do not fall out, and the members turned so that the bevelled peripheries 54 thereof are clear of the wall 48 of recess 45, the strips 39 can in turn be slid into the dovetail recesses of the appropriate walls of box 4. Then, using the Allen key, the members 52 are turned so that the bevelled peripheries 54 contact the recess walls 48 and clamp the two halves of box 4 together.

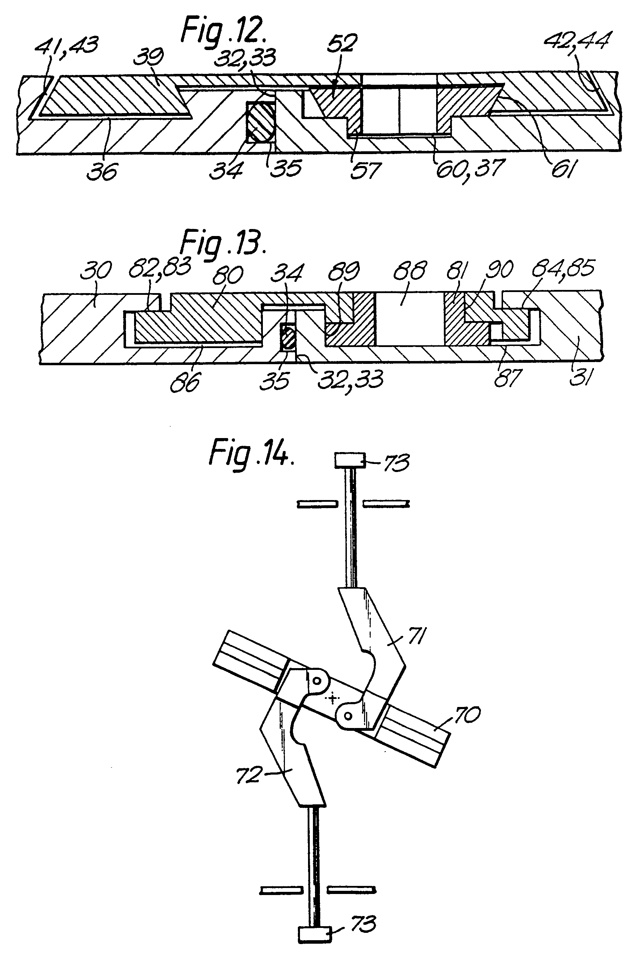

Figure 12 shows a modification in which the spigot portion 57 of each clamping member 52 extends inwardly into a blind hole 60 formed in the floor of the dovetail recess 37. The recess 45 extends over the members 52 and terminates in a bevelled wall 61 matching the bevelled peripheries 54 of the disc portions of the clamping members. The hexagonal recess of each member 52 opens at the disc portion side of the member (it could extend right through the member as shown) and each is turned so that its periphery engages the wall 61 and thereby clamps the two box halves together.

A further embodiment of the clamp arrangement is shown in Figure 13. The box halves 30, 31 are provided with recesses 86, 87 respectively. A clamping strip 80 fits into the recesses in each wall of the box. A spigot 81 fits into a well 88 formed in the strip 80 and engages with the one side 89 of the recess 87 and one side 90 of the well 88 to clamp the two halves 30, 31 together.

The tension latch on the door 5 of the cradle in Figures 1 to 4, could be replaced by a fastener of the kind shown in Figure 13. This comprises a lever or handle 70 pivoted at its centre to the door 5 and two tension members 71 and 72 pivoted to the lever 70 each side of its centre. The members 71 and 72 extend up and down respectively and terminate in hooks 73 able to engage respective ones of the hooks 13 and 16. When lever 70 is turned, the members 71 and 72 are pulled towards each other. Each is shaped to give an over-centre action retaining the lever in its closed position.

The clamping strip as described may be replaced by a similarly shaped piece of resilient material e.g. spring steel, which may be pushed into the recesses formed in each wall of the box as shown in Figures 6 and 12.

It may also be possible to further secure the clamping strip in the recesses by tapering both the strip and the recesses along their lengths.

## Claims

1. A clamping arrangement for clamping two members (30, 31) having mating edges (32, 33) which require to be clamped together in edge-to-edge relationships, comprising a member recess (36, 37, 86, 87) provided in each member, the member recesses being parallel to one another when the mating edges (32, 33) are positioned in edge-to-edge relationship, the member recesses having side walls (43, 44) remote from their respective mating edges (32, 33) and sidewalls (47, 49) adjacent to their respective mating edges (32, 33), the arrangement further comprising a clamping strip (39, 80) having edges (41, 42) which are shaped to match the respective remote side walls (43, 44) of the member recesses and the clamping strip having a recess (45) between its said two edges (41, 42) to receive wall portions of the two members, the clamping strip further being provided with at least one eccentric clamping member (52) rotatably suported by the clamping strip at least when said strip is engaged in the member recesses and capable of being turned so as to urge a side wall (46) of the recess (45) of the clamping strip tightly against one of said adjacent walls (47), thereby clamping the mating edges of the members together.

2. A clamping arrangement according to Claim 1 wherein at least the remote side walls (43, 44) of the member recesses (36, 37) are bevelled and the clamping strip (39) has its edges (41, 42) shaped to match the remote walls.

3. A clamping arrangement according to claim 1 wherein the member recesses (86, 87) include neck portions defined by the two parallel remote side walls and the clamping strip has its edges shaped to match the remote side walls.

4. A clamping arrangement according to Claim 1 and Claim 2 wherein the or each clamping member (52) engages one of the adjacent side walls (49) of the recess in which it lies.

5. A clamping arrangement according to Claim 1 or Claim 2 wherein the or each clamping member (52) engages a region of the clamping strip (39).

6. A clamping arrangement according to any one of the previous claims wherein the recesses (36, 37) in the members (30, 31) and the recess (45) in the clamping strip (39) are chosen to be of such depth that the clamping strip (39) can lie flush with the members (30, 31) when the members are clamped in edge-to-edge relationship.

## Patentansprüche

1. Klemmvorrichtung zum gegenseitigen Verspannen zweier Bauteile (30, 31), die jeweils Paßränder (32, 33) aufweisen, die gegeneinander verspannt werden müssen, wobei in jedem Bauteil eine Formausnehmung (36, 37, 86, 87) vorgesehen ist, die parallel zueinander verlaufen, wenn die Paßränder (32, 33) aneinanderliegen, wobei die Formausnehmungen Seitenwände (43, 44) entfernt von ihren jeweiligen Paßrändern (32, 33) und Seitenwände (47, 49) benachbart zu ihren jeweiligen Paßrändern (32, 33) aufweisen, und wobei die Vorrichtung außerdem einen Klemmstreifen (39, 80) aufweist, dessen Ränder (41, 42) so geformt sind, daß sie sich den jeweils entfernten Seitenwänden (43, 44) der Formausnehmungen anpassen und der eine Ausnehmung (45) zwischen seinen beiden Rändern (41, 42) aufweist, um Wandabschnitte der beiden Bauteile aufzunehmen, und wobei der Klemmstreifen außerdem mit wenigstens einem exzentrischen Klemmkörper (52) versehen ist, der drehbar vom Klemmstreifen wenigstens dann getragen wird, wenn dieser Streifen in die Formausnehmungen eingreift und der Klemmkörper so gedreht werden kann, daß eine Seitenwand (46) der Ausnehmung (45) des Klemmstreifens dicht gegen eine der benachbarten Wände (47) gedrückt wird, wodurch die Paßränder der Bauteile zusammengeklemmt werden.

2. Klemmvorrichtung nach Anspruch 1, bei welcher wenigstens die entfernten Seitenwände (43, 44) der Formausnehmungen (36, 37) abgeschrägt sind und der Klemmstreifen (39) an seinen Rändern (41, 42) so gestaltet ist, daß diese Ränder mit den entfernten Wänden zusammenpassen.

3. Klemmvorrichtung nach Anspruch 1, bei welcher die Formausnehmungen (86, 87) Halsabschnitte aufweisen, die durch zwei parallele entfernte Seitenwände gebildet werden, und der Klemmstreifen an seinen Rändern so gestaltet ist, daß er auf die entfernten Seitenwände angepaßt ist.

4. Klemmvorrichtung nach den Ansprüchen 1 und 2, bei welcher der oder jeder Klemmkörper (52) an einer der benachbarten Seitenwände (49) der Ausnehmung angreift, in der er liegt.

5. Klemmvorrichtung nach den Ansprüchen 1 oder 2, bei welcher der oder jeder Klemmkörper (52) an einen Bereich des Klemmstreifens (39) angreift.

6. Klemmvorrichtung nach einem der vorhergehenden Ansprüche, bei welcher die Ausnehmungen (36, 37) in den Bauteilen (30, 31) und die Ausnehmung (45) in dem Klemmstreifen (39) eine solche Tiefe haben, daß der Klemmstreifen (39) mit den Bauteilen (30, 31) fluchtet, wenn die Bauteile mit ihren Rändern aneinanderliegend verspannt sind.

## Revendications

1. Agencement de serrage pour serrer deux éléments (30, 31) ayant des bords d'accouplement (32, 33) qui doivent être serrés ensemble dans une relation bord à bord, comprenant un évidement d'élément (36, 37, 86, 87) ménagé dans chaque élément, les évidements des éléments étant parallèles l'un à l'autre lorsque les bords d'accouplement (32, 33) sont placés dans la position bord à bord, les évidements des éléments ayant des parois latérales (43, 44) distantes de leurs bords respectifs d'accouplement (32, 33) et des parois latérales (47, 49) contiguës à leurs bords respectifs d'accouplement (32, 33), l'agencement comportant en outre une bande de serrage (39, 80) ayant des bords (41, 42) qui sont façonnés pour être appariés aux parois latérales distantes respectives (43, 44) des évidements des éléments, et la bande de serrage ayant un évidement (45) entre ses deux bords (41, 42) pour recevoir des parties de paroi des deux éléments, la bande de serrage comportant en outre au moins un élément excentrique de serrage (52) supporté en rotation par la bande de serrage au moins lorsque ladite bande est engagée dans les évidements des éléments et pouvant être soumise à une rotation de façon à solliciter une paroi latérale (46) de l'évidement (45) de la bande de serrage étroitement contre l'une des parois adjacentes (47), d'où le serrage des bords d'accouplement des éléments.

2. Agencement de serrage selon la revendication 1, dans lequel au moins les parois latérales distantes (43, 44) des évidements (36, 37) des éléments sont chanfreinées et la bande de serrage (39) a ses bords (41, 42) façonnés de manière à être appariés aux parois distantes.

3. Agencement de serrage selon la revendication 1, dans lequel les évidements (86, 87) des éléments comprennent des parties à col définies par les deux parois latérales, distantes, parallèles et la bande de serrage a ses bords façonnés de manière à être appariés aux parois latérales distantes.

4. Agencement de serrage selon la revendication 1 et la revendication 2, dans lequel le ou chaque élément de serrage (52) est en contact avec l'une des parois latérales adjacentes (49) de l'évidement dans lequel il est situé.

5. Agencement de serrage selon la revendication 1 ou la revendication 2, dans lequel le ou chaque élément de serrage (52) est en contact avec une zone de la bande de serrage (39).

6. Agencement de serrage selon l'une quelconque des revendications précédentes, dans lequel les évidements (36, 37) des éléments (30, 31) et l'évidement (45) de la bande de serrage (39) sont choisis de façon à avoir une profondeur telle que la bande de serrage (39) peut être à ras des éléments (30, 31) lorsque les éléments sont serrés dans une relation bord à bord.

Fig. 1.

Fig. 2.

Fig .3.

Fig .4.

2

Fig.5.

Fig.6.

Fig.7.

Fig.8.

Fig.9.

Fig.10.

Fig.11.

4

## Fig.12.

## Fig.13.

## Fig.14.